# EUROPEAN PATENT SPECIFICATION

(11) **EP 2 510 536 B1**
(45) Date of publication and mention of the grant of the patent: **28.11.2018**
(21) Application number: 09771580.9
(22) Date of filing: 07.12.2009
(51) Int. Cl.: H01J 37/244, H01J 37/02, H01J 37/26

(54) **X-RAY ANALYSER**
RÖNTGENSTRAHLENANALYSATOR
ANALYSEUR AUX RAYONS X

(43) Date of publication of application: 17.10.2012
(73) Proprietor: Oxford Instruments Nanotechnology Tools Limited, Oxon OX13 5QX (GB)
(72) Inventor: BEWICK, Angus, Abingdon Oxfordshire OX14 3YD (GB); BHADARE, Santokh Singh, Greenford Middlesex UB6 8RZ (GB)
(74) Representative: Gill Jennings & Every LLP
(86) International application number: PCT/GB2009/051658
(87) International publication number: WO 2011/070309

(56) References cited:
- WO-A1-96/00451
- GB-A- 2 325 045
- JP-A- H0 883 588
- US-A- 5 075 555
- US-A- 5 317 154
- Pnsensors Gmbh: "PNSensor - Research and Development of Advanced Radiation Sensors", , 9 February 2007 (2007-02-09), XP055043766, Retrieved from the Internet: URL:http://web.archive.org/web/20070209125 813/http://www.pnsensor.de/Welcome/index.h tml [retrieved on 2012-11-09]
- P Leutenegger ET AL: "Silicon drift detectors as radiation monitor for X-, gamma rays and particles", Proceedings of SPIE - The International Society for Optical Engineering - 2000, vol. 4012, 1 January 2000 (2000-01-01), pages 579-591, XP055016568, ISBN: 0277786X
- Anonymous: "Magnetic properties of materials 2.6.6", , 22 December 2016 (2016-12-22), XP055331300, Retrieved from the Internet: URL:http://www.kayelaby.npl.co.uk/general_ physics/2_6/2_6_6.html [retrieved on 2016-12-22]

## Description

### Field of the Invention

The present invention relates to x-ray analysers for use with transmission electron microscopes (TEM).

### Background of the Invention

For x-ray analysis in an electron microscope (EM), an x-ray spectrum is measured by sensing and measuring the energies of individual x-ray photons emitted by a specimen when it is hit by a focussed electron beam. Each x-ray photon is an energetic particle and the energy is typically converted into charge using a solid state detector. Electrons which are scattered back from the sample, so called "backscattered electrons", may also travel towards the x-ray detector.

In the case of transmission electron microscopes (TEM), high energy electrons are used, typically having energies in excess of 100keV, and the specimen is normally very thin so that the incident beam is transmitted right through the specimen. Since there is very little scattering within the specimen, x-rays and backscattered electrons emerge from a very small volume of material with a spatial dimension mainly governed by the size of the focussed incident electron beam. Under high magnification conditions, the lens produces a strong magnetic field in the vicinity of the specimen and the backscattered electrons tend to follow spiral trajectories that travel back up into the gap within the lens pole piece.

Under low magnification conditions the lens field may not be strong enough to direct the backscattered electrons up inside the pole piece and some high energy backscattered electrons may travel towards the x-ray sensor. Furthermore, the specimen is usually mounted on a metal support grid and if the specimen is moved so that the incident beam falls on a thick grid bar, there will be a huge increase in the numbers of high energy x-rays and backscattered electrons generated. Therefore, when the operator is examining a specimen and moving either the specimen or the incident beam position, there may be conditions where the x-ray detector experiences a very high overload condition.

Prolonged exposure to high energy x-rays or electrons may cause radiation damage to the x-ray sensor so it is desirable to prevent the potentially damaging radiation from reaching the sensor when the sensor is thus exposed. These effects are discussed in detail for example by B G Lowe, in the book "X-ray Spectrometry in Electron Beam Instruments", eds D.B.Williams et al, Plenum Press, ISBN 0-306-44858-0, 1995, Chapter 2.

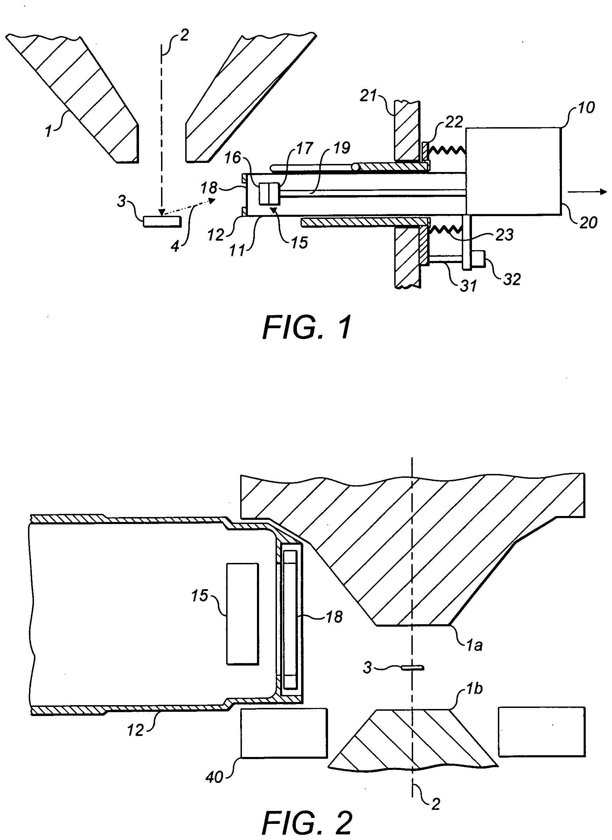

The electronics attached to the x-ray sensor can sense the overload condition and provide a signal to initiate action from a protective device. One solution is to use "autoretraction" to move the detector to a safe position. Fig. 2.6 in Lowe also shows a mechanism where the detector can be retracted behind a flap that blocks the exit of radiation. The flap, which is biased into a closed position, is forced into an open position by the detector tube when the detector is inserted into position near the specimen, for use. The flap closes upon withdrawal of the detector behind the flap. Lowe points out an undesirable effect of autoretraction when using a detector cooled by liquid nitrogen (LN2) because the LN2 dewar is heavy and the retraction movement can cause substantial vibration of the column. It is also evident from Fig 2.1 and 2.3 of Lowe that, in order to position the detector sensor very close to the specimen, the walls of the detector tube need to be as thin as possible.

Lowe suggests using a protective shutter that is inside the detector tube and close to the x-ray sensor because this does not require the heavy detector to be moved. The shutter is positioned such that at all times it is closer to the specimen than the sensor. Unlike a flap, which is a passive element used in conjunction with the withdrawal of the detector, a shutter is independently activated and does not require any movement of the detector. This shutter solution has been adopted practically by manufacturers.

Lowe also points out that any magnetic materials (for example some tungsten and all nickel alloys) in close proximity to the beam can cause astigmatism and shift. Thus, for TEM use, it is known that magnetic materials must be avoided in the structure of x-ray detectors. Aluminium is a reasonable choice for a non-magnetic material but is not very strong and is not a good absorber for x-rays. In contrast, 316 stainless steel is a strong and easily-machined material for making detector tubes and typically has a relative magnetic permeability of 1.02. Lower relative magnetic permeability of 1.005 can be achieved with 310 stainless steel and this has been used extensively for TEM detector designs (for example by Link Analytical Ltd and Oxford Instruments Analytical Ltd).

In practice, despite the precautions taken by the use of non-magnetic materials, the TEM image may still shift when the detector moves in or out. US5317154 (Honda) describes image shifts of typically 1 micron even when the x-ray detector is made out of non-magnetic material. Honda suggests that this shift is caused by a slight amount of residual magnetism in the detector, magnetic substances in the mechanism that moves the detector and due to electrostatic charging of any insulators on the surface of the detector.

Image shift can be accommodated when the microscope operator is in control of the microscope. For example, the operator can firstly move the detector and thereafter image the specimen and locate a feature of interest. However, if the detector is moved automatically in response to some signal and the movement is not initiated directly by the operator, the operator may suddenly see an unexpected shift of the image. If the magnitude of the unexpected shift of the image is larger than the field of view, then the operator will lose any reference to anything in the field of view and will have to search again to locate the feature of interest.

In the analysis of nanometre-scale materials, features of interest are typically of the order of a few nanometres in size and an unscheduled displacement greater than about 100 nanometres can often be enough for the operator to lose the feature location completely.

For these reasons the provision of a shutter has become the accepted mechanism by which x-ray sensors are protected from damage caused by backscattered electrons. Such shutters are typically formed from low magnetic permeability materials and are able to respond rapidly to any detected overload of the x-ray sensor thereby ensuring only minor beam movement as a result of the shutter activating.

WO 96/00451 A1 discloses an x-ray analysis apparatus with a pass-through shutter mechanism.

The object of our invention is to provide an effective means to protect the x-ray detector from excessive overload conditions that can occur in TEM operation whilst avoiding the use of shutters, the disadvantages of which are now discussed.

### Summary of the invention

In accordance with the present invention we provide a transmission electron microscope x-ray analyser comprising:-
a housing containing a silicon drift detector, the entire housing being moveable in use between an analysis position and a retracted position;
the housing having an end portion within which the silicon drift detector is contained, the end portion forming the part of the x-ray analyser positioned proximal to the beam of a transmission electron microscope when in use, wherein the material of the end portion is selected from the group of titanium, molybdenum, titanium-aluminium alloy, and phosphor bronze; and,
an automatic retraction system adapted to move the entire housing containing the silicon drift detector from the analysis position to the retracted position upon receipt of a trigger signal indicative of a condition in which the power level received by the silicon drift detector from impinging x-rays or electrons is above a predetermined threshold.

We have realised that, despite the strong historical preference within the art towards the use of shutters, there are some inherent problems with shutters which can be avoided by the use of the present invention.

For example a shutter internal to the analyser can prevent the detector from being positioned close to the specimen in some configurations. Large aperture analysers are designed to maximise the detection area, and contain detectors which are ideally positioned as close to the specimen as possible. The provision of a necessarily large shutter (to cover the detector dimensions) between the detector and the window at the end of the analyser tube prevents the detector being placed adjacent to the window and therefore reduces the detection solid angle available. When the shutter is closed, there must be enough blocking material to cover the whole active area of the detector and when the shutter is open this material has to be moved away to the side and this requires additional space that may limit how close to the specimen the detector sensor can be positioned. A further problem with shutters is that the provision of moveable parts within a vacuum environment (either the analyser or the TEM chamber itself) can cause a reduction in the quality of the vacuum which may reduce the detector performance. Forming the required mechanical connections from the control system is also difficult and provides a further potential source of contamination of the vacuum.

The provision of a retractable analyser without a shutter overcomes these problems.

We have therefore taken some novel steps to make the autoretraction device an effective and practical reality for nanometre-scale analysis.

The automated retraction operation may be initiated by the transmission electron microscope, for example when the microscope is placed into a state in which the lens excitation is unable to trap a sufficient number of the backscattered electrons. The transmission electron microscope generates the trigger signal when placed in this state since this corresponds to the condition in which the power levels received by the detector exceed the predetermined threshold. Such a microscope state may exist when the microscope is placed in a low magnification mode. Alternatively, or in addition, the energies of the particles (x-rays and/or electrons) entering the analyser may be monitored by the provision of an overload sensing device. Typically in this case the trigger signal is an overload signal which is generated within the detector electronics of the analyser and which automatically initiates the detector retraction. The overload may be detected when the energy dissipation rate in the detector caused by the arriving particles exceeds a certain threshold level. A separate device may be provided to monitor the energy deposition rate of the impinging electrons and x-rays. However, conveniently the silicon drift detector output itself may be used for this purpose. The entire housing containing the silicon drift detector is moved by the autoretraction system. A number of suitable positioning mechanisms may be used to achieve this, including the use of a lead screw and motor. Additional bellows may be provided to ensure a vacuum seal is maintained between the moveable analyser housing and the microscope.
To reduce mechanical vibration of the microscope during retraction, the use of a heavy liquid nitrogen-based cooling system (which typically comprises a dewar containing liquid nitrogen) is avoided. This is made possible by the use of a silicon drift detector. A silicon drift detector is advantageous since it provides excellent detection performance, can be cooled effectively using Peltier cooling and is also lightweight. A suitable Peltier cooling system may take a number of configurations. However, preferably a Peltier stack is provided in thermal contact with the detector and a heat pipe is provided to remove the heat from the detector to a distal location.
The silicon drift detector is provided within an x-ray sensor package. Substantially non-magnetic materials are preferably used for the components of the x-ray sensor package, and preferably each component. Since the package does not have to be mechanically strong, there are a wide range of materials that are suitable.
The end portion of the detector, which is typically tubular, is the part that is closest to the specimen in the microscope when in use. A material is selected that is strong enough to make a thin walled tube, is a good x-ray absorber and is not likely to have any residual magnetism. While 310 stainless steel can have a relative magnetic permeability approaching 1.005, this can vary with the method of manufacture. During experimentation we have previously identified image shift that is due to residual magnetism in the detector tube rather than any of the other effects suggested by Honda. Therefore the material of the end portion is important since it is closest to the specimen when in use. A material which has a lower permeability than 310 stainless steel, and preferably much lower, is used for the end portion according to the invention.
Thus, the surrounding end portion of the housing is formed from a lightweight, very low magnetic permeability material with good strength and x-ray absorption capability. The relative magnetic permeability of the material is less than 1.004, more preferably less than 1.002, even more preferably less than 1.001 and most preferably less than 1.0001. Typically the material of the end portion is a metal having a largest constituent by weight selected from the group of: titanium, copper, molybdenum. Thus the material may be a pure metal such as titanium or molybdenum or an alloy such as titanium-aluminium or phosphor bronze. According to the claimed invention, the material of the end portion is selected from the group of titanium , molybdenum, titanium-aluminium alloy and phosphor bronze.

The use of lightweight materials is advantageous in that it provides the ability to move the analyser from the analysis to the retracted position very rapidly without the need for a large and powerful carriage mechanism and motor. With the analyser according to the invention, the analyser may be moved from the analysis position to the retracted position within a few seconds. The advantage of this rapid movement is that it minimises the potential damage to the silicon drift detector. A further advantage is that the period of disturbance to the operation of the microscope is also minimised.
The analyser preferably further comprises an outer tubular housing having a bore through which at least the end portion may pass upon moving between the analysis and retracted positions. Typically this outer tubular housing is sealed to the microscope when in use and the end portion and detector are passed through the outer tubular housing to be inserted into the analysis position within the microscope chamber. Optionally the outer tubular housing may be provided with a flap which is adapted to be moved to an open position when the silicon drift detector is in the analysis position and to be moved to a closed position, thereby closing off the bore, when the silicon drift detector is in the retracted position. Such a flap provides additional protection of the silicon drift detector when it is withdrawn to the retracted position (beyond the flap) and also reduces the possibility of high energy particles from escaping the microscope chamber.

With the analyser of the invention it is possible to conduct improved nanometre-scale analysis since the deflection of the electron beam of the transmission electron microscope is preferably less than 100 nanometres.

### Brief Description of the Drawings

An example of a transmission electron microscope x-ray analyser according to the invention is now described with reference to the accompanying drawings, in which:-
Figure 1 is a schematic representation of the arrangement of the analyser within a transmission electron microscope; and,
Figure 2 is a view, partly in section, of an analyser according to a practical example in an analysis position.

### Description of Example

A transmission electron microscope arrangement with an example x-ray analyser according to the invention is shown in Figure 1. The transmission electron microscope 100 has a lens pole piece 1a having a central aperture through which a focussed beam of electrons 2 impinges upon a specimen 3. A second lens pole piece 1b is positioned beneath the specimen in a known manner. The beam is accelerated by a strong electric field which provides electrons in the beam 2 with energies of typically at least 100keV. The electrons are focussed by a number of electromagnetic lenses within the electron microscope column and pole piece. The relative arrangement of the pole pieces 1a,1b, beam 2 and specimen 3 is well known within the art. The high energy electrons cause x-rays and electrons 4 to be emitted/scattered from the specimen. In x-ray analysis it is these x-rays which are desired to be monitored and characterised using an x-ray analyser.
An x-ray analyser according to this example of the invention is shown at 10. This is formed from an elongate tube 11 of circular cross section, a first end of which forms an end portion 12 which is constructed from a very low relative magnetic permeability material. In practice the whole tube 11 could be formed from the same material as the end portion 12. The tube 11 is evacuated and contains an x-ray sensor package 15 adjacent to the first end within the end portion 12. The package 15 includes a silicon drift detector 16 and local Peltier cooling assembly 17. A super atmosphere supporting thin window (SATW) 18 is located in the first end of the end portion 12 through which the x-rays and backscattered electrons pass prior to detection by the silicon drift detector. An elongate heat pipe 19 has one end located in thermal communication with the detector package 15 and the other in thermal communication with a heat sink and cooling fins external to the microscope in a main body 20 of the analyser. The main body 20 also includes a power supply and control electronics for the analyser 10.
The tube 11 passes through a chamber wall 21 of the transmission electron microscope. The analyser has an outer tubular housing which attaches to a port in the microscope chamber wall 21. The housing is provided with a vacuum seal 22 surrounding the tube 11 so that the tube can be moved to and fro relative to the chamber wall 21 in a linear direction parallel with the tube 11 axis whilst maintaining the vacuum within the chamber. The main body 20 of the analyser 10 is mounted to the outer tubular housing and remains external to the vacuum environment within the transmission electron microscope. It is preferred that an ultra-high vacuum is maintained within the microscope chamber. The integrity of the vacuum within the chamber is ensured by the provision of external bellows 23 mounted at one end to the housing and at the other to the main body 20 of the analyser. The bellows allow for movement between the analysis and retracted positions of the tube 11 and main body 20 of the analyser 10 relative to the outer tubular housing.

The analyser 10 is fitted with an autoretraction system. Movement of the analyser 10 with respect to the microscope is achieved with a lead screw 31 and motor 32. The activation of the motor in forward and reverse directions causes the analyser 10 to be moved by the lead screw along an axis parallel to the elongate dimension of the tube 11. This, together with appropriate stops representing the two extreme positions of analyser movement, allows the analyser 10 to be moved between the analysis position at which the analyser 10 is located for use in detecting x-rays and electrons, and the retracted positioned where the analyser 10 is subjected to a much reduced power level from incoming x-rays or electrons. An arrow showing movement during retraction is indicated in Figure 1. More effective protection is provided if the detector tube is retracted behind a protective flap 50. Figure 1 shows a preferred arrangement where the flap is hinged and falls shut under the force of gravity when the analyser is retracted. The flap 50 is mounted to the outer tubular housing of the analyser and is deflected to an open position when the tube 11 is passed through the tubular housing. The flap 50 closes the bore of the outer tubular housing when the tube 11 is withdrawn.
The position of the analyser 10 is under the control of the autoretraction system during the operation of the microscope. The autoretraction system includes a microprocessor which monitors the signal produced by the silicon drift detector 16. The microprocessor may form part of the microscope control system or be part of separate controller electronics. The silicon drift detector and microprocessor act as an overload sensing device whereby if the power level detected within the silicon drift detector exceeds a predetermined threshold level, then, if the analyser 10 is positioned in the analysis position an overload signal is generated which causes the motor 32 to be operated and the lead screw 31 to move the analyser 10 to the retracted position. This operation is performed within a few seconds in this example although it could be made faster if required. Similarly the output of the silicon drift detector may be monitored when moving the analyser 10 from the retracted position towards the analysis position. If during such movement the silicon drift detector experiences a power level in excess of the threshold then the overload signal is generated and the processor may reverse the direction of the lead screw 31 to return the analyser 10 to the retracted position. Furthermore, if the microscope controls are set to a low magnification state where the detector is likely to be exposed to an overload condition, the microscope produces a signal which is connected to the autoretraction system so that, irrespective of the overload sensing device, the detector is directed to the retracted position whenever this microscope signal is present.

Figure 2 is a view, partly in section showing the analyser 10 when located at the analysis position, which is the position of closest approach to the specimen. As can be seen from Figure 2, there is clearly very restricted space if the detector is to be positioned close to the specimen. This is due to the shape of the upper pole piece 1a which lies on the electron filament side of the specimen, and the lower pole piece 1b which lies on the opposite side of the specimen with respect to the pole piece 1a. The tube 11 forming the analyser housing has an external diameter of 20 mm in this example.

As a comparative example a design was tested using 316 stainless steel for the tube 11 and conventional materials for the x-ray sensor package, these being a header formed from 304 stainless steel and pins formed from a nickel-containing alloy. Under typical working conditions for the microscope, when the detector was retracted, a shift in excess of 1 micron was observed in the beam position. When the tube was changed to a 310 stainless steel and lower magnetic permeability materials were used for the x-ray sensor package (316 stainless steel for the header and pins), the shift under the same conditions was reduced to 0.2 micron. Thus, such material solutions were not sufficient to reduce the interference with the microscope beam to satisfactory levels (100 nanometres or less), as had been noticed by Honda.

In the present example as shown in Figure 2, novel materials are used for the analyser 10. The end portion 12 is constructed in the form of an end cap using titanium. Titanium absorbs x-rays much better than aluminium and, as is shown in Fig.2, can be machined down to thicknesses less than 0.5 mm yet still be strong enough for the detector housing to support 1 atmosphere of external atmospheric pressure. The wall thickness of the end portion in Figure 2 is 0.4 mm. The permeability of commercially pure titanium is less than 1.0001. As a result, with the titanium end-cap, the beam shift under the same conditions was reduced to 50nm when the detector was moved from the analysis position to the retracted position.

Figure 2 also shows the position of the SATW window 18 fitted within a flat end of the titanium end portion 12 . The extreme end of the end portion 12 is narrowed in cross-section to form a snout which conforms with the shape of the upper pole piece 1a of the microscope column. This allows the snout to pass beneath the external edge of the upper pole piece 1a and the anticontaminator device 40 beneath, adjacent to the lower 1b pole piece, thereby maximizing the flux of x-rays received by the detector during normal operation so as to obtain a strong x-ray signal for analysis.

The analyser according to the present invention performs conventional x-ray analysis operations in a similar manner to known detectors. However, in the event of a threshold power level of x-rays or electrons being received, the autoretraction system operates to withdraw the analyser to a safe retracted position where the silicon drift detector will not be damaged.

Thus, by using a silicon drift detector of low weight, a housing modified to reduce residual magnetism to well below the levels normally used in "non-magnetic" designs and an autoretraction system that retracts the analyser to a safe position when overload is detected, we have invented an effective system for providing x-ray detection in a TEM which is suitable for analysing nanometre-scale features.

## Claims

1. A transmission electron microscope x-ray analyser (10) comprising:-
a housing containing a silicon drift detector (16), the entire housing being moveable in use between an analysis position and a retracted position;
the housing having an end portion (12) within which the silicon drift detector is contained, the end portion forming the part of the x-ray analyser positioned proximal to the beam (2) of a transmission electron microscope when in use, wherein the material of the end portion is selected from the group of titanium, molybdenum, titanium-aluminium alloy, and phosphor bronze; and,
an automatic retraction system adapted to move the entire housing containing the silicon drift detector from the analysis position to the retracted position upon receipt of a trigger signal indicative of a condition in which the power level received by the silicon drift detector from impinging x-rays or electrons (4) is above a predetermined threshold.

2. An x-ray analyser according to claim 1, further comprising an overload sensing device adapted to generate the trigger signal when the overload sensing device detects that the power level received by the silicon drift detector (16) from impinging x-rays or electrons (4) is above the predetermined threshold.

3. An x-ray analyser according to claim 1 or claim 2, wherein the silicon drift detector (16) is cooled when in use by a Peltier cooling system (17) comprising a Peltier stack in thermal contact with the detector and a heat pipe (19).

4. An x-ray analyser according to any of the preceding claims, wherein each of the components of the silicon drift detector (16) are substantially non-magnetic materials.

5. An x-ray analyser according to any of the preceding claims, wherein the predetermined threshold is a threshold representative of a power level above which the detector may suffer damage.

6. An x-ray analyser according to any of the preceding claims, wherein the automatic retraction system is adapted to move the detector between the analysis and retracted positions in a few seconds or less.

7. An x-ray analyser according to any of the preceding claims, wherein the relative magnetic permeability of the end portion (12) is less than 1.001.

8. An x-ray analyser according to claim 7, wherein the relative magnetic permeability of the end portion (12) is less than 1.0001.

9. An x-ray analyser according to any of the preceding claims, further comprising a positioning mechanism arranged to effect the movement of the analyser with respect to the transmission electron microscope.

10. An x-ray analyser according to any of the preceding claims, further comprising bellows (23) arranged to provide a vacuum seal between the moveable analyser (10) and the microscope.

11. An x-ray analyser according to any of the preceding claims, further comprising an outer tubular housing having a bore through which at least the end portion (12) may pass upon moving between the analysis and retracted positions, the outer tubular housing having a flap (50) which is adapted to be moved to an open position when the silicon drift detector is in the analysis position and to be moved to a closed position, thereby closing off the bore, when the silicon drift detector is in the retracted position.

## Patentansprüche

1. Transmissionselektronenmikroskop-Röntgenanalysator (10), Folgendes umfassend:
ein Gehäuse, das einen Siliciumdriftdetektor (16) enthält, wobei das gesamte Gehäuse in Verwendung zwischen einer Analyseposition und einer eingefahrenen Position bewegbar ist;
wobei das Gehäuse einen Endabschnitt (12) aufweist, in dem der Siliciumdriftdetektor enthalten ist, wobei der Endabschnitt den Teil des Röntgenanalysators ausbildet, der proximal zu dem Strahl (2) eines Transmissionselektronenmikroskops ist, wenn es in Verwendung ist, wobei das Material des Endabschnitts aus der Gruppe aus Titan, Molybdän, Titan-Aluminium-Legierung und Phosphorbronze ausgewählt ist; und
ein automatisches Einfahrsystem, das angepasst ist, das gesamte Gehäuse, das den Siliciumdriftdetektor enthält, von der Analyseposition in die eingefahrene Position zu bewegen, nachdem ein Auslösesignal empfangen wurde, das einen Zustand anzeigt, in dem der durch den Siliciumdriftdetektor empfangene Leistungspegel von auftreffenden Röntgenstrahlen oder Elektronen (4) über einem vorgegebenen Schwellenwert liegt.

2. Röntgenanalysator nach Anspruch 1, ferner eine Überlasterfassungsvorrichtung umfassend, die angepasst ist, das Auslösesignal zu erzeugen, wenn die Überlasterfassungsvorrichtung erkennt, dass der durch den Siliciumdriftdetektor (16) empfangene Leistungspegel von auftreffenden Röntgenstrahlen oder Elektronen (4) über dem vorgegebenen Schwellenwert liegt.

3. Röntgenanalysator nach Anspruch 1 oder 2, wobei der Siliciumdriftdetektor (16), wenn er in Verwendung ist, durch ein Peltier-Kühlsystem (17) gekühlt wird, das einen Peltier-Stapel in thermischem Kontakt mit dem Detektor und ein Wärmerohr (19) umfasst.

4. Röntgenanalysator nach einem der vorhergehenden Ansprüche, wobei jede der Komponenten des Siliciumdriftdetektors (16) im Wesentlichen unmagnetische Materialien sind.

5. Röntgenanalysator nach einem der vorhergehenden Ansprüche, wobei der vorgegebene Schwellenwert ein Schwellenwert ist, der einen Leistungspegel darstellt, über dem der Detektor Schäden erleiden kann.

6. Röntgenanalysator nach einem der vorhergehenden Ansprüche, wobei das automatische Einfahrsystem angepasst ist, den Detektor in einigen Sekunden oder weniger zwischen der Analyse- und der eingefahrenen Position zu bewegen.

7. Röntgenanalysator nach einem der vorhergehenden Ansprüche, wobei die relative magnetische Permeabilität des Endabschnitts (12) weniger als 1,001 beträgt.

8. Röntgenanalysator nach Anspruch 7, wobei die relative magnetische Permeabilität des Endabschnitts (12) weniger als 1,0001 beträgt.

9. Röntgenanalysator nach einem der vorhergehenden Ansprüche, ferner umfassend einen Positionierungsmechanismus, der angeordnet ist, die Bewegung des Analysators bezogen auf das Transmissionselektronenmikroskop zu bewirken.

10. Röntgenanalysator nach einem der vorhergehenden Ansprüche, ferner einen Balg (23) umfassend, der angeordnet ist, eine Vakuumdichtung zwischen dem bewegbaren Analysator (10) und dem Mikroskop bereitzustellen.

11. Röntgenanalysator nach einem der vorhergehenden Ansprüche, ferner umfassend ein äußeres röhrenförmiges Gehäuse mit einer Bohrung, die wenigstens der Endabschnitt (12) nach dem Bewegen zwischen der Analyse- und der eingefahrenen Position durchlaufen kann, wobei das äußere röhrenförmige Gehäuse eine Klappe (50) aufweist, die angepasst ist, in eine offene Position bewegt zu werden, wenn der Siliciumdriftdetektor sich in der Analyseposition befindet, und in eine geschlossene Position bewegt zu werden, wodurch die Bohrung abgesperrt wird, wenn der Siliciumdriftdetektor sich in der eingefahrenen Position befindet.

## Revendications

1. Analyseur à rayons X de microscope électronique en transmission (10) comprenant :
un boîtier contenant un détecteur au silicium à diffusion (16), le boîtier entier étant mobile en utilisation entre une position d'analyse et une position rétractée ;
le boîtier ayant une portion d'extrémité (12) au sein de laquelle le détecteur au silicium à diffusion est contenu, la portion d'extrémité formant la partie de l'analyseur à rayons X positionnée proximale au faisceau (2) d'un microscope électronique en transmission lorsqu'il est en utilisation, dans lequel le matériau de la portion d'extrémité est choisi dans le groupe du titane, du molybdène, d'un alliage de titane-aluminium et du bronze phosphoreux ; et,
un système de rétraction automatique adapté pour déplacer le boîtier entier contenant le détecteur au silicium à diffusion de la position d'analyse à la position rétractée lors de la réception d'un signal de déclenchement indicatif d'une condition dans laquelle le niveau de puissance reçu par le détecteur au silicium à diffusion en provenance de rayons X ou d'électrons incidents (4) est au-dessus d'un seuil prédéterminé.

2. Analyseur à rayons X selon la revendication 1, comprenant en outre un dispositif de détection de surcharge adapté pour générer le signal de déclenchement lorsque le dispositif de détection de surcharge détecte que le niveau de puissance reçu par le détecteur au silicium à diffusion (16) en provenance de rayons X ou d'électrons incidents (4) est au-dessus du seuil prédéterminé.

3. Analyseur à rayons X selon la revendication 1 ou la revendication 2, dans lequel le détecteur au silicium à diffusion (16) est refroidi lorsqu'il est en utilisation par un système de refroidissement Peltier (17) comprenant un empilement Peltier en contact thermique avec le détecteur et un caloduc (19).

4. Analyseur à rayons X selon l'une quelconque des revendications précédentes, dans lequel les composants du détecteur au silicium à diffusion (16) sont chacun des matériaux sensiblement non magnétiques.

5. Analyseur à rayons X selon l'une quelconque des revendications précédentes, dans lequel le seuil prédéterminé est un seuil représentatif d'un niveau de puissance au-dessus duquel le détecteur peut subir un dommage.

6. Analyseur à rayons X selon l'une quelconque des revendications précédentes, dans lequel le système de rétraction automatique est adapté pour déplacer le détecteur entre les positions d'analyse et rétractée en quelques secondes ou moins.

7. Analyseur à rayons X selon l'une quelconque des revendications précédentes, dans lequel la perméabilité magnétique relative de la portion d'extrémité (12) est inférieure à 1,001.

8. Analyseur à rayons X selon la revendication 7, dans lequel la perméabilité magnétique relative de la portion d'extrémité (12) est inférieure à 1,0001.

9. Analyseur à rayons X selon l'une quelconque des revendications précédentes, comprenant en outre un mécanisme de positionnement conçu pour effectuer le déplacement de l'analyseur par rapport au microscope électronique en transmission.

10. Analyseur à rayons X selon l'une quelconque des revendications précédentes, comprenant en outre des soufflets (23) conçus pour fournir un joint à vide entre l'analyseur mobile (10) et le microscope.

11. Analyseur à rayons X selon l'une quelconque des revendications précédentes, comprenant en outre un boîtier tubulaire extérieur ayant un orifice de passage à travers lequel peut passer au moins la portion d'extrémité (12) lors du déplacement entre les positions d'analyse et rétractée, le boîtier tubulaire extérieur ayant un rabat (50) qui est adapté pour se déplacer vers une position ouverte lorsque le détecteur au silicium à diffusion est dans la position d'analyse et pour être déplacé vers une position fermée, fermant ainsi l'orifice de passage, lorsque le détecteur au silicium à diffusion est dans la position rétractée.
